# FASCICULE DE BREVET EUROPEEN

(11) **EP 0 568 439 B1**
(45) Date de publication et mention de la délivrance du brevet: **14.12.1994**
(21) Numéro de dépôt: 93401085.1
(22) Date de dépôt: 27.04.1993
(51) Int. Cl.: G11C 29/00

(54) **Procédé et circuit de détection de fuites de courant dans une ligne de bit**
Detektionsverfahren und -schaltung für Stromverluste in einer Bitleitung
Process and circuit for detecting current leaks in a bit line

(30) Priorité: 30.04.1992 FR 9205420
(43) Date de publication de la demande: 03.11.1993
(73) Titulaire: SGS-THOMSON MICROELECTRONICS S.A., 94250 Gentilly (FR)
(72) Inventeur: Rouy, Olivier, Cabinet BALLOT-SCHMIT, F-75116 Paris (FR)
(74) Mandataire: Schmit, Christian Norbert Marie

(56) Documents cités:
- EP-A- 0 146 975
- US-A- 4 800 332
- US-A- 4 841 482
- I.B.M. TECHN. DISC. BULL. vol. 33, no. 5, Octobre 1990, pages 389 - 390 'bitline leakage screen for directory chips'

## Description

L'invention concerne un circuit électronique qui permet de détecter des fuites de courant anormales sur une ligne de bit d'une mémoire morte programmable électriquement. Elle concerne aussi le procédé associé et un circuit mémoire comportant un tel circuit de détection.

L'invention est particulièrement destinée à améliorer le test des mémoires en sortie de la chaîne de fabrication. Le test des mémoires consiste à répertorier tous les éléments défaillants. Ces informations sont ensuite utilisées pour déterminer si la mémoire est réparable ou non. La réparation consiste à activer des éléments de redondance du circuit pour remplacer les éléments défaillants.

On comprend qu'il est utile de pouvoir identifier tous les éléments défaillants. D'abord parce qu'il faut fournir au client des circuits opérationnels. Ensuite parce qu'il faut être sûr que le circuit livré au client est fiable et qu'il ne va pas tomber en panne avant une durée de vie garantie par le fabricant.

Or en ce qui concerne plus particulièrement les lignes de bit des mémoires mortes programmables électriquement, on peut être gêné par des fuites de courant trop importantes sur les lignes de bit.

On rappelle que les cellules de telles mémoire sont organisées en lignes et colonnes, les cellules d'une même ligne ayant leurs grilles reliées ensemble à une ligne de mot, les cellules d'une même colonne ayant leurs drains reliés à une ligne de bit. Toutes les sources d'un même secteur mémoire sont reliées ensemble.

Un décodeur de lignes de mot permet d'adresser une ligne de mot particulière et d'appliquer des potentiels déterminés selon le mode de fonctionnement.

Un décodeur de lignes de bit permet de sélectionner une ligne de bit particulière pour la connecter à un élément de circuit déterminé selon le mode de fonctionnement.

Une cellule mémoire est adressée par sélection d'une ligne de bit et d'une ligne de mot.

En lecture, la sélection d'une ligne de mot consiste à porter cette ligne à un potentiel de lecture de 5 volts par exemple. Toutes les autres lignes de mot sont portées à zéro volts.

En lecture, la sélection d'une ligne de bit entraîne sa connection à un amplificateur de lecture par un convertisseur courant/tension qui délivre une tension image du courant de la ligne de bit.

La cellule adressée en lecture consomme ou non du courant sur la ligne de bit selon son état vierge ou programmé. Un potentiel correspondant s'établit en sortie du convertisseur courant/tension. La lecture se fait alors par comparaison dans l'amplificateur de lecture de ce potentiel avec celui fourni par un circuit de référence connecté à une cellule vierge, le principe étant qu'une cellule vierge conduit à 5 volts et qu'une cellule programmée ne conduit pas (ou peu).

En pratique, si le potentiel est inférieur à celui du circuit de référence, c'est à dire si la cellule adressée consomme du courant, la cellule de la ligne de bit est vierge ou effacée.

S'il est supérieur, c'est à dire si la cellule adressée ne consomme pas de courant, elle est programmée.

Or si il y a des fuites de courant importantes sur la ligne de bit, on pourra croire que la cellule adressée est effacée alors qu'en réalité elle sera programmée : Les fuites de courant masquent l'état réel de la cellule.

Ces fuites de courant peuvent être des fuites au niveau de certaines jonctions source-substrat des cellules, dues à un défaut de fabrication. Elles peuvent aussi provenir d'une cellule trop déplétée, pour laquelle une tension de grille à 0 volt suffit pour la faire conduire. Si la cellule réellement adressée ne conduit pas, son état programmé sera masqué par l'état effacé d'une cellule trop déplétée située sur la même ligne de bit. Ce problème de cellules déplétées se rencontre sur les mémoires effaçables électriquement, pour lesquelles une tension d'effacement appliquée trop longtemps ou une tension d'effacement trop élevée va trop décharger la grille flottante et dépléter la cellule.

Le brevet US-A-4 841 482 décrit un circuit et un procédé pour vérifier les courants de fuite dans les mémoires flash. En particulier, ce test consiste à placer une tension positive sur la grille d'une cellule mémoire et à mesurer le courant sur son drain. La tension positive de test peut être comprise entre 0-3 volts. Le document ne décrit pas comment la mesure de courant de test est effectuée.

Dans l'invention, on propose une solution qui ne modifie pas la structure du plan mémoire. Dans l'invention, on veut détecter le défaut pour si possible le corriger.

Aussi on propose un circuit de détection de fuites de courant sur les lignes de bit d'une mémoire, et utilisable en test afin de répertorier les lignes de bit souffrant d'un tel défaut, pour les réparer ensuite, quand c'est possible.

Le circuit de détection de fuites de courant est un circuit électronique, qui permet de comparer le courant passant dans chacune des lignes de bit du plan mémoire à un courant de test, lorsque toutes les lignes de mot sont portées à zéro volts. En effet, dans ces conditions, les cellules ne devraient pas conduire, car leur seuil de conduction est de 2 à 2,5 volts par exemple pour une cellule vierge et au minimum de 5 volts pour une cellule programmée. Mais si une cellule est déplétée, c'est à dire si son seuil de conduction est négatif ou nul, ou s'il y a une fuite de jonction, un courant est conduit par la ligne de bit. Ce courant de fuite est comparé au courant de test. Si ce courant de fuite est supérieur au courant de test, la ligne de bit pourra être répertoriée comme étant défaillante.

L'invention concerne donc un circuit intégré comprenant un plan de cellules mémoires mortes programmables électriquement, organisé en lignes de bit et lignes de mot et comportant un circuit de détection de courants de fuites sur une ligne de bit, comprenant un circuit de contrôle pour commander la mise à la masse des grilles des cellules d'une ligne de bit.

Il est principalement caractérisé en ce que le circuit de contrôle applique une tension de commande à un générateur de courant en mode de détection. Un circuit de comparaison permet de détecter un courant de fuite sur une ligne de bit supérieur au courant délivré par le générateur de courant.

L'invention concerne aussi un procédé de détection de fuites sur une ligne de bit.

D'autres caractéristiques et avantages de l'invention sont détaillés dans la description qui suit, faite en référence aux dessins annexés dans lesquels,
- la figure 1 est un schéma du principe de l'invention,
- la figure 2 représente un mode préféré de réalisation du principe de l'invention

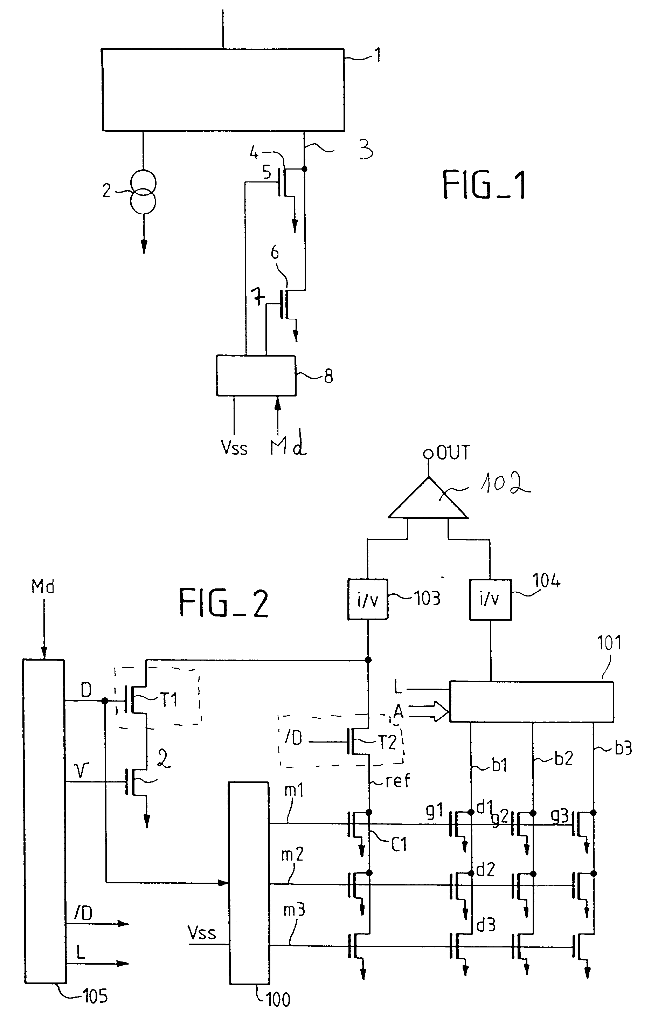

Le principe de l'invention est représenté sur la figure 1.

Un circuit de comparaison 1 est relié en entrée d'une part à un générateur de courant 2 et d'autre part à une ligne de bit 3. Le générateur de courant 3 délivre un courant de test. La ligne de bit 3 comprend deux cellules mémoire 4 et 6. Dans l'invention les cellules mémoire 4,6 ont leurs grilles 5,7 commandées par un circuit de commande 8 qui met à la masse ces grilles sur réception d'un signal de mode de détection Md.

Le principe de détection est le suivant : le seuil de conduction d'une cellule vierge ou effacée est de l'ordre de 2,5 volts et le seuil de conduction de cellules programmées est au minimum de 5 volts dans un exemple. Donc en appliquant 0 volt sur leurs grilles en mode de détection, les cellules 4 et 6 ne vont pas conduire qu'elles soient programmées ou vierges, puisque la tension qui leur est appliquée est inférieure aux seuils de conduction.

Cependant supposons par exemple que la cellule 4 soit anormalement déplétée. Cela veut dire que son seuil de conduction est négatif ou nul: la cellule 4 va donc conduire avec une tension de grille nulle et on va avoir un courant sur la ligne de bit 3.

Le circuit de comparaison compare ce courant au courant de test délivré par le générateur de courant. Si le courant de la ligne bit est supérieur, il y a une fuite de courant gênante et la sortie du circuit de comparaison délivre une information de défaillance. Le courant de test sera avantageusement de l'ordre de 10 microampères ou même moins.

Le principe général de l'invention est donc de détecter une fuite de courant sur une ligne de bit en comparant le courant délivré par cette ligne de bit au courant de test délivré par un générateur de courant, alors que toutes les cellules de la ligne de bit ont leur grille à zéro volts.

On peut ainsi détecter des fuites de courant trop importantes qui vont gêner le fonctionnement normal du circuit mémoire. Dans l'exemple d'une cellule 4 déplétée on va détecter qu'il y a une fuite de courant sur la ligne de bit 3 et on va répertorier la ligne de bit 3 comme étant un élément défaillant de la mémoire. Si au lieu d'une cellule déplétée on a une fuite de jonction vers le substrat sur une ligne de bit, on aura aussi un courant de fuite sur la ligne de bit 3. Si ce courant est supérieur au courant de test que l'on a fixé par le générateur de courant, on va détecter alors que sur la ligne de bit 3, il y a une fuite de courant trop importante et répertorier cette ligne de bit comme élément défaillant.

Eventuellement, le courant de test délivré par le générateur de courant peut avoir une valeur différente selon la classe de fiabilité recherchée (par exemple, en fonction du nombre de cycles d'écriture/lecture recherché).

La figure 2 représente une réalisation du principe de l'invention appliqué à un exemple de circuit mémoire. Le champ mémoire représenté comprend 3 lignes de bit b1, b2, b3 et 3 lignes de mot m1, m2, m3. Les drains d1, d2, d3 des cellules d'une ligne de bit b1 particulière sont tous reliés à cette ligne de bit. Les grilles g1, g2, g3 des cellules d'une ligne de mot m1 particulière, sont toutes reliées à cette ligne de mot. Les lignes de mot sont commandées par un décodeur 100 de lignes de mot. Les lignes de bits sont commandées par un décodeur 101 de lignes de bit.

Le circuit de détection comprend un circuit de comparaison, un moyen de contrôle et un générateur de courant.

Le circuit de comparaison comporte de préférence un comparateur 102, un convertisseur courant/tension 103 dont l'entrée est connectée au générateur de courant 2 et la sortie au comparateur, et un autre convertisseur courant/tension 104 dont l'entrée est connectée en mode de détection à une ligne de bit sélectionnée et la sortie au comparateur.

Le moyen de contrôle 105 reçoit de l'extérieur une commande de mode de détection Md et délivre un signal de détection D, un signal inversé de détection /D et un potentiel de commande V du générateur de courant 2. Ce générateur de courant est dans l'exemple de la figure 2 un transistor dont le drain est relié au convertisseur courant/tension 103 du circuit de détection, dont la source est reliée à la masse et dont la grille est commandée par le potentiel de commande V. De préférence, le transistor qui forme le générateur de courant est un transistor très résistif qui va donc laisser passer un faible courant. D'autres réalisations du générateur de courant peuvent être envisagées, comme par exemple en utilisant une cellule mémoire.

Le décodeur 100 de lignes de mot reçoit le signal de détection D et la référence de masse Vss.

Le fonctionnement est alors le suivant :
sur activation d'un signal de mode de détection Md, le moyen de contrôle 105 active le signal de détection D et fournit le potentiel de commande V sur la grille du transistor formant le générateur de courant 2. Ce potentiel de courant peut être variable. Il peut être commandé de l'extérieur ou réglé en interne sur le circuit.

Sur activation du signal de détection D, le décodeur 100 de lignes de mot porte toutes ses lignes de mot à la masse Vss. Chaque ligne de bit, est alors adressée en détection l'une après l'autre. Ceci peut se faire par un séquenceur interne activé par le moyen de contrôle 105, ou par un banc de test externe, qui présente les adresses A successivement au décodeur 101 de lignes de bit. Quand une ligne de bit est adressée en mode de détection, le décodeur de ligne de bit connecte la ligne de bit à une entrée du comparateur 102 par le convertisseur courant/tension 104 du circuit de détection. Le convertisseur courant/tension 103 associé au générateur de courant 2 du circuit de détection est connecté à l'autre entrée du comparateur. Le comparateur délivre en sortie OUT le résultat de la comparaison entre les deux valeurs de tension images du courant qui circule dans la ligne de bit et du courant de test délivré par le générateur de courant. L'information de sortie est par exemple exploitée par un circuit non représenté qui répertorie tous les éléments défaillants.

On peut alors sélectionner la ligne de bit suivante et on passe ainsi en revue toutes les lignes de bit du secteur mémoire associé à l'amplificateur de lecture.

On teste de cette manière l'ensemble des champs de la mémoire et en fin de procédure, un testeur pourra regarder quels sont tous les éléments défaillants et déterminer si il y a une possibilité de réparation pour chaque ligne de bit défaillante.

De préférence, le moyen de contrôle 105 du circuit de détection fournit un potentiel de commande V du générateur de courant qui peut varier. Ainsi selon la destination du circuit, on va utiliser un courant de test plus ou moins important selon l'exigence de la fiabilité par exemple décrite dans un cahier des charges.

En général un champ mémoire tel que celui décrit comporte un circuit de lecture qui comprend une cellule de référence vierge pour chacune des lignes de mot. Les cellules de référence sont plaçées sur une ligne de bit de référence notée ref sur la figure 2. La grille d'une cellule de référence est connectée à la ligne de mot correspondante et on a ainsi une cellule de référence par ligne de mot dans un champ mémoire. En mode de lecture, la ligne de bit d'une cellule sélectionnée est connectée par le décodeur 101 de lignes de bit à un amplificateur de lecture du champ mémoire considéré par un convertisseur courant/tension. La ligne de bit de référence ref est connectée à l'amplificateur de lecture par un convertisseur courant/tension. L'amplificateur de lecture compare les valeurs de tension images du courant que la cellule sélectionnée conduit et du courant commandé par la cellule de référence vierge associée à laquelle est appliquée la même tension de grille que la cellule sélectionnée (elles sont sur la même ligne de mot).

Dans l'invention, on prévoit d'incorporer le circuit de détection à un tel circuit de lecture. Pour cela, on propose avantageusement d'introduire un premier transistor de commutation T1 en série entre le convertisseur courant/tension 103 et le générateur de courant 2 du circuit de détection et un deuxième transistor de commutation T2 en série entre ce même convertisseur courant/tension 103 et la ligne de bit ref des cellules de référence. Le premier transistor de commutation T1 est commandé sur sa grille par le signal de détection D délivré par le moyen de contrôle 105. Le deuxième transistor de commutation T2 est commandé sur sa grille par le signal de détection inversé /D. Le comparateur 102 du circuit de lecture est avantageusement l'amplificateur de lecture du champ mémoire considéré. Enfin un même convertisseur courant/tension 104 est utilisé en mode de lecture et en mode de détection par le décodeur 101 de lignes de bit pour connecter une ligne de bit à l'amplificateur de lecture 102, sur réception par le décodeur 101 d'un signal de commande L activé par le moyen de contrôle 105 du circuit de détection ou par un moyen non représenté associé au circuit de lecture.

Ainsi, en incorporant le circuit de détection au circuit de lecture, on utilise un seul circuit de comparaison pour deux fonctions différentes et l'on va commuter d'une fonction sur l'autre selon le mode de fonctionnement de la mémoire : mode de lecture ou mode de détection.

Ainsi, par une circuiterie électronique relativement simplifiée, on va pouvoir effectuer une détection fiable et complète qui s'effectue simplement et qui permet de déterminer quelles sont les lignes de bit conduisant des courants de fuite trop importants. L'incorporation avantageuse de ce circuit de détection à un circuit de lecture de la mémoire est relativement aisée et ne nécessite pas beaucoup de modifications comme on l'a vu. Les avantages obtenus sont considérables du point de vue du test et de la réparation du circuit mémoire.

## Revendications

1. Circuit intégré comprenant un plan de cellules mémoires mortes programmables électriquement, organisé en lignes de bit et lignes de mot, et comportant un circuit de détection de courant de fuite sur une ligne de bit (3; b1, b2 ou b3) comprenant un circuit de contrôle (8; 105) pour mettre à la masse la grille de toutes les cellules (4,6) de la ligne de bit (3; b1, b2 ou b3), caractérisé en ce que le circuit de détection de courant comprend également un circuit générateur de courant (2), en ce que le circuit de contrôle applique en mode de détection (Md) une tension de commande (V) au générateur de courant et en ce que le circuit de détection de courant comprend également un circuit de comparaison (1) connecté d'une part à la ligne de bit (3; b1, b2 ou b3) et d'autre part au générateur de courant (2) pour détecter un courant de fuite sur la ligne de bit supérieure au courant délivré par le générateur de courant.

2. Circuit intégré selon la revendication 1, caractérisé en ce que le circuit de comparaison comporte un comparateur (102), un premier convertisseur courant/tension (103) dont l'entrée est connectée au générateur de courant et dont la sortie est connectée au comparateur, et un deuxième convertisseur courant/tension (104) dont l'entrée est connectée en mode de détection à une ligne de bit sélectionnée (b1, b2 ou b3) et dont la sortie est connectée au comparateur.

3. Circuit intégré selon la revendication 2, caractérisé en ce qu'il comporte en outre un circuit de référence (ref) avec au moins une cellule de référence connectée à l'entrée d'un convertisseur courant/tension pour effectuer la lecture d'une cellule du plan mémoire par comparaison avec la cellule de référence, le premier convertisseur (103) étant aussi le convertisseur du circuit de référence, le circuit de détection comprenant un premier transistor de commutation (T1) commandé sur sa grille par un signal de détection (D) et placé en série entre le convertisseur (103) et le générateur de courant (2), et un deuxième transistor de commutation (T2) commandé sur sa grille par le signal de détection inversé (/D) et placé en série entre le convertisseur (103) et le circuit de référence (ref).

4. Circuit intégré selon l'une des revendications précédentes, caractérisé en ce que les cellules mémoires sont agencées en lignes de bit (b1, b2, b3) et en lignes de mot (m1, m2, m3), les grilles des cellules d'une même ligne de mot sont reliées ensemble à cette ligne de mot, un décodeur (100) des lignes de mot reçoit un signal de détection (D) du circuit de contrôle (105) et lorsque le signal de détection est actif, le décodeur de lignes de mot porte toutes les lignes de mots à la masse.

5. Circuit intégré selon l'une des revendications précédentes, caractérisé en ce que la tension de commande (V) délivrée par le moyen de contrôle (105) est variable.

6. Procédé de détection de fuites sur une ligne de bit d'un plan mémoire en circuit intégré organisé en lignes de bit et lignes de mot, comprenant les étapes suivantes :
- on sélectionne une ligne de bit;
- on applique zéro volts sur toutes les lignes de mot;
et caractérisé en ce qu'il comprend également les étapes suivantes :
- on applique une tension de commande (V) sur un générateur de courant (2) pour obtenir un courant de test et
- on compare le courant circulant sur la ligne de bit sélectionnée au courant de test pour déterminer s'il y a une fuite de courant sur cette ligne de bit sélectionnée.

## Patentansprüche

1. Integrierte Schaltung, die eine Anordnung von elektrisch programmierbaren Festspeicherzellen, organisiert in Bitleitungen und Wortleitungen, aufweist und eine Detektionsschaltung für Verluststrom auf einer Bitleitung (3; b1, b2 oder b3) umfaßt, aufweisend eine Steuerschaltung (8; 105), um die Steuerelektrode sämtlicher Zellen (4, 6) der Bitleitung (3; b1, b2 oder b3) an Masse zu legen, dadurch **gekennzeichnet**, daß die Stromdetektionsschaltung ebenfalls eine Stromerzeugungsschaltung (2) aufweist, daß die Steuerschaltung in der Detektionsbetriebsart (Md) an den Stromerzeuger eine Steuerspannung (V) anlegt, und daß die Stromdetektionsleitung ebenfalls eine Vergleichsschaltung (1) aufweist, die zum einen mit der Bitleitung (3; b1, b2 oder b3) und zum anderen mit dem Stromerzeuger (2) verbunden ist, um auf der Bitleitung einen Verluststrom größer als der von dem Stromerzeuger abgegebene Strom zu detektieren.

2. Integrierte Schaltung nach Anspruch 1, dadurch **gekennzeichnet**, daß die Vergleichsschaltung einen Komparator (102), einen ersten Strom/Spannungsumsetzer (103), dessen Eingang mit dem Stromerzeuger verbunden ist und dessen Ausgang mit dem Komparator verbunden ist, und einen zweiten Strom/Spannungsumsetzer (104) umfaßt, dessen Eingang in der Detektionsbetriebsart mit einer ausgewählten Bitleitung (b1, b2 oder b3) verbunden ist und dessen Ausgang mit dem Komparator verbunden ist.

3. Integrierte Schaltung nach Anspruch 2, dadurch **gekennzeichnet**, daß sie außerdem eine Referenzschaltung (ref) mit wenigstens einer Referenzzelle umfaßt, die mit dem Eingang eines Strom/Spannungsumsetzers verbunden ist, um das Lesen einer Zelle der Speicheranordnung durch Vergleich mit der Referenzzelle auszuführen, wobei der erste Umsetzer (103) auch der Umsetzer der Referenzschaltung ist, wobei die Detektionsschaltung einen ersten Schalttransistor (T1), der auf seiner Steuerelektrode durch ein Detektionssignal (D) gesteuert wird und in Reihe zwischen dem Umsetzer (103) und dem Stromerzeuger (2) angeordnet ist, und einen zweiten Schalttransistor (T2) aufweist, der auf seiner Steuerelektrode durch das umgekehrte Detektionssignal (/D) gesteuert wird und in Reihe zwischen dem Umsetzer (103) und der Referenzschaltung (ref) angeordnet ist.

4. Integrierte Schaltung nach einem der vorhergehenden Ansprüche, dadurch **gekennzeichnet**, daß die Speicherzellen in Bitleitungen (b1, b2, b3) und in Wortleitungen (m1, m2, m3) aufgebaut sind, die Steuerelektroden der Zellen einer selben Wortleitung zusammen mit dieser Wortleitung verbunden sind, ein Decodierer (100) der Wortleitungen ein Detektionssignal (D) der Steuerschaltung (105) empfängt und, wenn das Detektionssignal aktiv ist, der Wortleitungsdecodierer sämtliche Wortleitungen auf Masse bringt.

5. Integrierte Schaltung nach einem der vorhergehenden Ansprüche, dadurch **gekennzeichnet**, daß die durch die Steuereinrichtung (105) abgegebene Steuerspannung (V) variabel ist.

6. Detektionsverfahren für Verluste auf einer Bitleitung auf einer Speicheranordnung in integrierter Schaltung, organisiert in Bitleitungen und Wortleitungen, umfassend die folgenden Schritte:
- Es wird eine Bitleitung ausgewählt;
- es werden Null Volt an sämtliche Wortleitungen angelegt;
und dadurch **gekennzeichnet**, daß es die folgenden Schritte umfaßt:
- Es wird eine Steuerspannung (V) an einen Stromerzeuger (2) angelegt, um einen Teststrom zu erhalten, und
- es wird der auf der ausgewählten Bitleitung fließende Strom mit dem Teststrom verglichen, um zu bestimmen, ob es einen Stromverlust auf dieser ausgewählten Bitleitung gibt.

## Claims

1. Integrated circuit comprising a plane of electrically programmable read-only memory cells, organised in bit lines and word lines and including a circuit for detecting leakage current on a bit line (3; b1, b2 or b3) comprising a control circuit (8; 105) for earthing the gate of all the cells (4, 6) of the bit line (3; b1, b2 or b3), characterised in that the current detector circuit also comprises a current generating circuit (2), in that the control circuit, in detection mode (Md), applies a control voltage (V) to the current generator, and in that the current detector circuit also comprises a comparator circuit (1) connected on the one hand to the bit line (3; b1, b2 or b3) and on the other hand to the current generator (2) in order to detect a leakage current on the bit line greater than the current delivered by the current generator.

2. Integrated circuit according to Claim 1, characterised in that the comparator circuit includes a comparator (102), a first current to voltage convertor (103), the input of which is connected to the current generator and the output of which is connected to the comparator, and a second current to voltage convertor (104), the input of which is connected in detection mode to a selected bit line (b1, b2 or b3) and the output of which is connected to the comparator.

3. Integrated circuit according to Claim 2, characterised in that it also includes a reference circuit (ref) with at least one reference cell connected to the input of a current to voltage convertor in order to read a cell in the memory plane by comparison with the reference cell, the first convertor (103) also being the convertor of the reference circuit, the detector circuit comprising a first switching transistor (T1) controlled at its gate by a detection signal (D) and mounted in series between the convertor (103) and the current generator (2), and a second switching transistor (T2) controlled at its gate by the inverted detection signal (/D) and mounted in series between the convertor (103) and the reference circuit (ref).

4. Integrated circuit according to one of the preceding claims, characterised in that the memory cells are arranged in bit lines (b1, b2, b3) and word lines (m1, m2, m3), the gates of the cells in any one word line are connected together to this word line, a decoder (100) for the word lines receives a detection signal (D) from the control circuit (105) and, when the detection signal is active, the word line decoder earths all the word lines.

5. Integrated circuit according to one of the preceding claims, characterised in that the control voltage (V) delivered by the control means (105) is variable.

6. Method for detecting leakages on a bit line of an integrated-circuit memory plane organised in bit lines and word lines, comprising the following steps:
- a bit line is selected;
- a zero voltage is applied to all the word lines;
and characterised in that it also comprises the following steps:
- a control voltage (V) is applied to a current generator (2) in order to obtain a test current, and
- the current flowing on the selected bit line is compared with the test current in order to determine if there is a current leakage on this selected bit line.
